**Europäisches Patentamt**

**European Patent Office**

**Office européen des brevets**

(19)

(11) Veröffentlichungsnummer: **0 224 630 B1**

(12) **EUROPÄISCHE PATENTSCHRIFT**

(45) Veröffentlichungstag der Patentschrift:
29.08.90

(51) Int. Cl.⁵: **C25D 1/10**, B01D 59/18

(21) Anmeldenummer: 86103636.6

(22) Anmeldetag: 18.03.86

(54) Verfahren zur Herstellen einer Vielzahl plattenförmiger Mikrostrukturkörper aus Metall.

(30) Priorität: 22.10.85 DE 3537483

(43) Veröffentlichungstag der Anmeldung:
10.06.87 Patentblatt 87/24

(45) Bekanntmachung des Hinweises auf die Patenterteilung:
29.08.90 Patentblatt 90/35

(84) Benannte Vertragsstaaten:
AT CH DE FR GB IT LI NL SE

(56) Entgegenhaltungen:
EP-A- 0 098 919
EP-A- 0 143 223
FR-A- 2 301 355
US-A- 3 649 474

(73) Patentinhaber: KERNFORSCHUNGSZENTRUM
KARLSRUHE GMBH, Weberstrasse 5 Postfach 3640,
D-7500 Karlsruhe 1(DE)

(72) Erfinder: Ehrfeld, Wolfgang, Dr., Reutstrasse 27,
D-7500 Karlsruhe 41(DE)
Erfinder: Hagmann, Peter, Dr., Nagoldstrasse 9c,
D-7514 Leopoldshafen(DE)
Erfinder: Maner, Asim, Dr., Guntherstrasse 1,
D-7513 Stutensee-1(DE)
Erfinder: Münchmeyer, Dietrich, Dr., Hagäckerstrasse 5,
D-7513 Stutensee-3(DE)
Erfinder: Becker, Erwin, Prof. Dr., Strählerweg 18,
D-7500 Karlsruhe 41(DE)

ACTORUM AG

## Beschreibung

Die Erfindung betrifft ein Verfahren zum Herstellen einer Vielzahl plattenförmiger Mikrostrukturkörper aus Metall nach dem Oberbegriff von Patentanspruch 1.

Ein Verfahren dieser Art ist aus der EP-A 0 143 223 bekannt. Dabei wird das die Mikrostrukturen aufweisende Werkzeug mit Reaktionsharz gefüllt und überschichtet; die überstehende Reaktionsharzmasse wird bis auf die Stirnflächen des Werkzeugs plan abgefräst. Die plane Fläche wird mit einer kunststoffbeschichteten, elektrisch leitfähigen Substratplatte abgedeckt, wobei als Kunststoff ein Positivfotolack verwendet wird. Nach der Abformung wird der Fotolack an den offenliegenden Bereichen der Formschicht belichtet und anschließend mit Lösungsmittel abgelöst, so daß an diesen Stellen elektrisch leitfähige Substratoberflächen erhalten werden.

Die Erfindung hat zur Aufgabe, ein Verfahren der gattungsgemäßen Art so zu gestalten, daß sich der Herstellungsaufwand verringern läßt und auch Mikrostrukturen mit hohem Aspektverhältnis bei kleinsten charakteristischen Abmessungen von wenigen Mikrometern gefertigt werden können.

Für die Lösung dieser Aufgabe werden die im Kennzeichen des Patentanspruchs enthaltenen Maßnahmen vorgeschlagen.

Bei dem erfindungsgemäßen Verfahren bildet die elektrisch leitende Abformmasse unmittelbar die elektrisch zusammenhängende Elektrode für das galvanische Auffüllen der hiermit verbundenen Negativformen der Mikrostrukturen mit einem Metall.

Ein Ausführungsbeispiel des Verfahrens wird im folgenden anhand der Figuren 1 bis 6 erläutert:

Figur 1 zeigt als Beispiel für einen plattenförmigen Mikrostrukturkörper eine Mikrostruktur 20 aus metallischen Sechskantprismen 21 im Grundriß, die auf einer Grundplatte 19 gehalten werden.

Die Figuren 2 bis 6 verdeutlichen die Durchführung des erfindungsgemäßen Verfahrens anhand von Querschnitten.

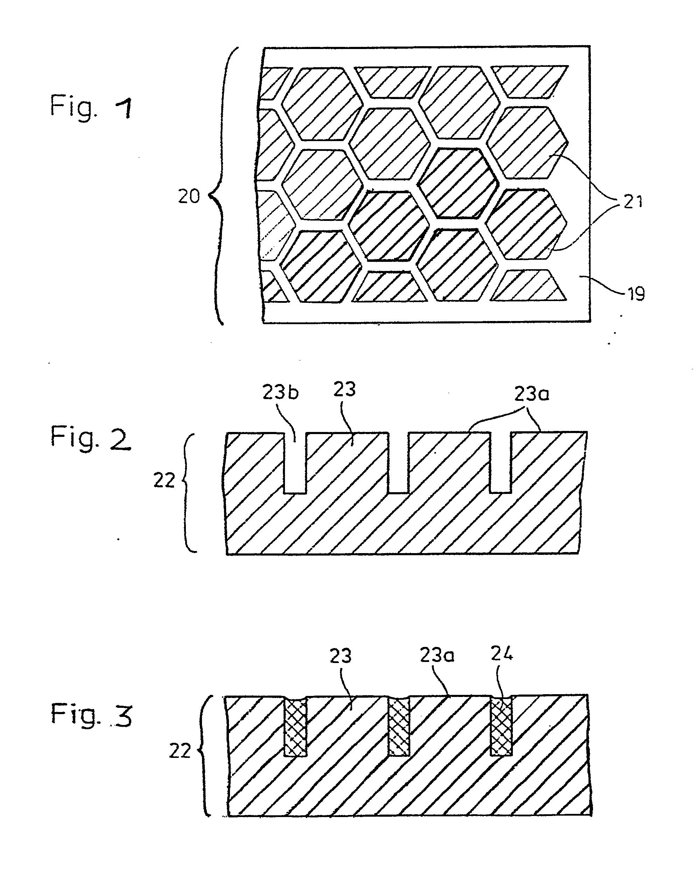

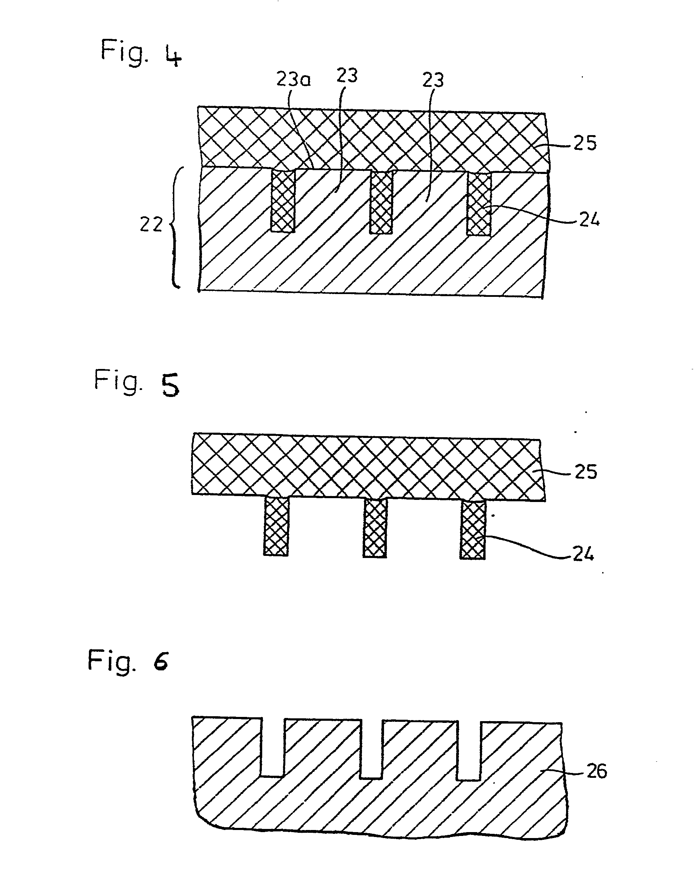

Figur 2 zeigt ein Werkzeug 22, das dem Mikrostrukturkörper 20 entspricht. Als elektrisch isolierende Abformmasse 24 wird ein kalthärtendes Gießharz (PLEXIT 74 mit 4 Gew.-% Katalysator Typ 20, beides erhältlich von Fa. Röhm) verwendet und auf das Werkzeug 22 aufgegossen. Sofort anschließend wird das über die Stirnflächen 23a der Mikrostrukturen 23 des Werkzeugs 22 überstehende Material mit einer rakelartigen Vorrichtung abgestrichen, so daß nur noch die Zwischenräume 23b der Mikrostrukturen 23 mit Abformmasse 24 ausgefüllt sind (Figur 3). Nach dem teilweisen Aushärten dieser Abformmasse 24 wird darüber als elektrisch leitfähige Abformmasse 25 ein Gemisch aus 25 Gewichtsteilen des Rußes CORAX L, 50 Gewichtsteilen PLEXIT 74, 5 Gewichtsteilen Katalysator Typ 20 und 20 Gewichtsteilen Methylmethacrylat geschichtet (Figur 4). Nachdem beide Abformmassen 24, 25 vollständig ausgehärtet sind, wird entformt, wobei die Schicht aus elektrisch leitender Abformmasse 25 als Handhabe dient (Figur 5). Durch galvanisches Auffüllen der so erzeugten Negativform 24, 25 unter Verwendung der elektrisch leitenden Schicht 25 als Elektrode und anschließendes Entfernen der Negativform 24, 25 erhält man den plattenförmigen Mikrostrukturkörper 26 aus Metall (Figur 6), der dem in Figur 1 im Grundriß dargestellten Körper entspricht.

## Patentansprüche

Verfahren zum Herstellen einer Vielzahl plattenförmiger Mikrostrukturkörper aus Metall, bei dem durch wiederholtes Abformen eines die Mikrostrukturen aufweisenden Werkzeugs mit einer elektrisch isolierenden Abformmasse Negativformen der Mikrostrukturen erzeugt werden, die mittels einer elektrisch leitenden, als Elektrode dienenden Schicht galvanisch mit einem Metall aufgefüllt werden, wonach die Negativformen entfernt werden, und bei dem die elektrisch isolierende Abformmasse auf das Werkzeug aufgegossen und das über die Stirnflächen der Mikrostrukturen des Werkzeugs überstehende Material abgestrichen wird, dadurch gekennzeichnet, daß nach dem teilweisen Aushärten der elektrisch isolierenden Abformmasse (24) über diese und das Werkzeug (22) eine elektrisch leitfähige Abformmasse (25) geschichtet wird, und daß, nachdem beide Abformmassen (24, 25) vollständig ausgehärtet sind, entformt wird.

## Claims

Process for producing a plurality of plate-like microstructural bodies from metal, wherein, by repeatedly moulding a tool, which includes the microstructures, utilising an electrically insulating moulding compound, negative moulds of the microstructures are produced which are galvanically filled with a metal by means of an electrically conductive layer, which serves as an electrode, whereupon the negative moulds are removed, and wherein the electrically insulating moulding compound is poured onto the tool, and the material protruding beyond the end faces of the microstructures of the tool is scraped-off, characterised in that, after the partial hardening of the electrically insulating moulding compound (24), an electrically conductive moulding compound (25) is distributed in a layer over said electrically insulating moulding compound and the tool (22), and in that the mould is opened after both moulding compounds (24, 25) are completely hardened.

## Revendications

Procédé de fabrication d'un corps présentant une microstructure à plans multiples en métal, par lequel, par moulage répété d'un outil possédant les microstructures, avec une masse de moulage isolant électriquement, des formes négatives des microstructures sont obtenues, qui à l'aide d'une couche servant comme électrode, conduisant l'électricité, sont rechargées avec un métal, après quoi les formes négatives sont éliminées et pour lequel la masse de moulage isolant électrique est versée sur l'outil et le matériau qui est saillant au dessus des faces frontales des microstructures de l'outil est raclé, caractérisé en ce qu'après le durcissement partiel de la masse de moulage isolante électriquement (24) au dessus de celle-ci et de l'outil (22), une masse de moulage conductrice de l'électricité (25) est appliquée en couche et en ce qu'elle est démoulée après que les deux masses de moulage (24, 25) soient complètement durcies.

Fig. 1

Fig. 2

Fig. 3

Fig. 4

Fig. 5

Fig. 6